# EUROPEAN PATENT APPLICATION

(11) **EP 4 539 298 A1**
(43) Date of publication of application: **16.04.2025**
(21) Application number: 24202473.5
(22) Date of filing: 25.09.2024
(51) Int. Cl.: H02J 13/00

(54) **DETECTION AND DISAGGREGATION OF ELECTRICAL VEHICLE CHARGING**

(30) Priority: 29.09.2023 US 202363541686 P; 06.09.2024 US 202418827336
(71) Applicant: ITRON, INC., Liberty Lake, WA 99019 (US)
(72) Inventor: ROOSTAEI, Bahman, Liberty Lake, 99019 (US)
(74) Representative: Morrall, Jonathan Ian McLachlan

(57) **Abstract**

A system and method for disaggregation of customer electrical usage to detect an electrical vehicle (EV) charger from among other electrical devices. An example electricity meter includes a processor, memory device(s), and applications including a model for detecting EV charging. An example model: associates data from a time-series of paired voltage and current measurements with a moving time-window including a plurality of sub-windows having a cumulative duration of the moving time-window; adds a new sub-window having at least one new paired voltage and current measurement to the moving time-window, and deletes an old sub-window, in a continuing manner; determines a value of power, and a value of volt-amps-reactive, for each sub-window within the moving time-window, wherein a stream of paired P and Q values is created; and determines, based on the stream of paired P and Q values, if an EV was charged and estimates the amount of EV charging power or energy.

## Description

### RELATED APPLICATIONS

This patent application claims benefit of priority to U.S. patent application serial no. 63/541,686, titled "DETECTION AND DISAGGREGATION OF ELECTRICAL VEHICLE CHARGING", filed on 09/29/2023, which is incorporated herein by reference.

### BACKGROUND

Electrical vehicle charging is becoming more common around the globe. This may result in unprecedented peak usages, which may result in transformer overloads and accelerated wear, outages from fuse and circuit breaker tripping, and generalized stress on electrical supply grids. To perform counter-measures and reduce the effect of such charging, it is important to gather more data, more accurately, and more quickly.

### BRIEF DESCRIPTION OF THE DRAWINGS

The detailed description is described with reference to the accompanying figures. In the figures, the left-most digit(s) of a reference number identifies the figure in which the reference number first appears. The same numbers are used throughout the drawings to reference like features and components. Moreover, the figures are intended to illustrate general concepts, and not to indicate required and/or necessary elements.
FIG. 1 is a block diagram showing an example electricity grid configured for disaggregation of loads and detection of electric vehicle (EV) charging on customer premises.
FIG. 1A is a block diagram showing example characteristics of an electricity metering system configured for disaggregation of loads and detection of electric vehicle (EV) charging on a utility customer's premises.
FIG. 2 is a block diagram showing techniques for developing, deploying, and operating various models and features of EV load detection.
FIG. 3 is a block diagram showing an electricity grid configured for operating machine-learning algorithms, load disaggregation, and EV load detection.
FIG. 4 is a diagram showing techniques utilizing windows and sub-windows in time to manage data.
FIG. 5 is a block diagram showing techniques for analyzing data obtained from windows in time.
FIG. 6 is a flowchart showing techniques for post-processing of data, and decision-making regarding whether EV charging was performed.
FIG. 7 is a flowchart showing an example method for electrical load disaggregation and for the detection of EV charging.
FIG. 8 is a flowchart showing an example of the use of windows and sub-windows as a tool in the disaggregation and detection processes.

### DETAILED DESCRIPTION

### Overview

Systems and methods for disaggregation of electrical loads from customer's electricity usage and for detection of electrical vehicle (EV) charging are discussed. Aspects of the systems and methods are performed at edge-based computing devices (e.g., an electricity meter) and/or at cloud-based computing devices (e.g., a server at a utility company office).

Electric vehicle loads are growing quickly globally, and present unprecedented peaks in load in residential areas where large (e.g., > 4kW) loads were not as common. This poses risks for distribution transformer lifetime through accelerated loss of life due to overload as well as unplanned outages from fuse and circuit breaker tripping.

### Example System and Techniques

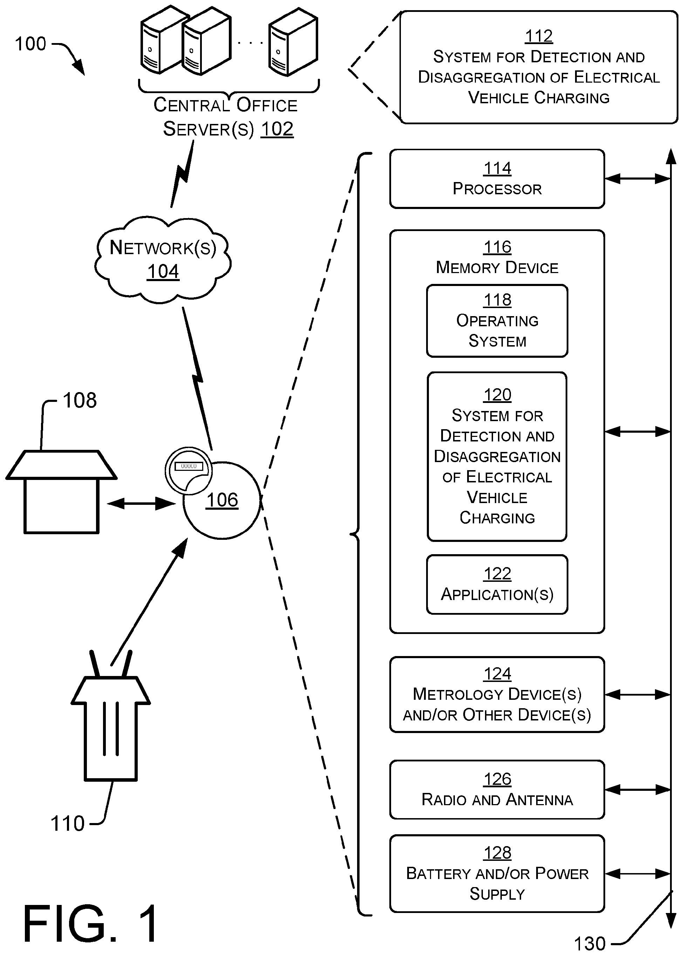

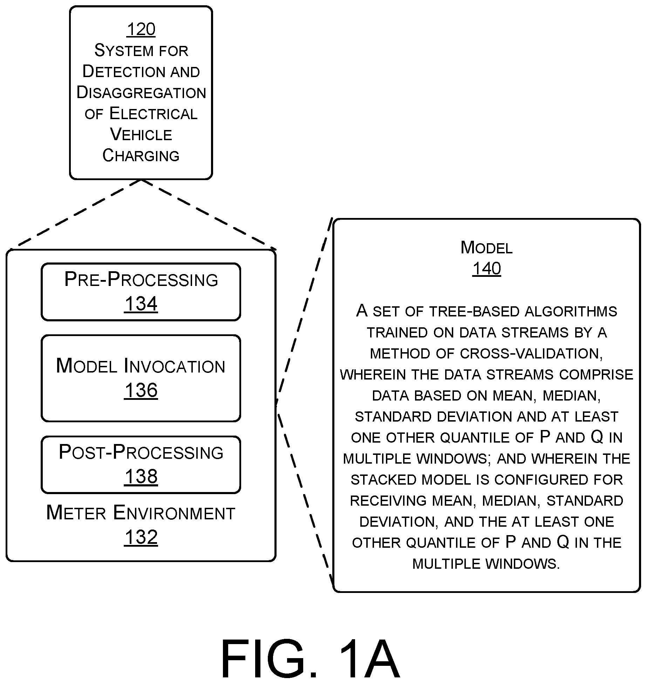

FIG. 1 shows an example system 100 for disaggregation of loads and detection of electric vehicle (EV) charging on residential premises. The system 100 may be implemented either at the edge device level (e.g., the electricity meter level), at the electricity company server level, and/or at the "cloud" level. In the example shown, portions of the system 100 reside on the central office servers, while portions reside on the electricity meter.

The example system 100 includes an electricity grid, a communications system, an example edge device (i.e., the electricity meter), and cloud computing devices (i.e., the central office servers). The system 100 includes central office servers 102 and communications networks 104. The networks 104 may include one or more of the internet, utility company proprietary network(s), and may utilize radio, powerline communications (PLC), mesh networks, star networks, etc.

A smart electricity meter 106 serves a customer site 108, and is representative of many such meters and sites, which may number in the thousands or hundreds of thousands. In the example shown, the smart electricity meter 106 is in communication with the central office server(s) 102 through the network 104. A transformer 110 is configured to serve one or more customers, and provides low voltage service that is measured by the smart electricity meter 106. The transformer 110 is representative of many such transformers, which may number in the thousands or hundreds of thousands.

A system 100 for disaggregation of loads and detection of EV charging on residential premises may be located on the central office server 102 and/or on the smart electricity meter 106. For purposes of illustration, FIG. 1 shows portions of the system 112 located on the central office server 102 and portions of the system 120 located on the smart electricity meter 106.

In the example shown, the smart electricity meter 106 includes a processor 114 and memory device 116. The memory device 116 may include software programs, that when executed by the processor 114, perform useful functions. As an example, an operating system 118 is representative of the low-level software, drivers, functions, etc., of the smart metering device. In the example of FIG. 1, a system 120 having software for disaggregation of loads and detection of EV charging is shown. Additionally, other applications 122 provide functionality related to: electricity consumption metering; hardware, electricity grid functionality, software diagnostics; and/or customer billing; etc.

The smart electricity meter 106 may include metrology device(s) 124, which may measure consumption of a commodity, such as electricity, natural gas, or water. The examples discussed herein describe systems 112 and 120 that are directed to electricity. However, corresponding systems could be constructed for use with natural gas and/or water. Accordingly, the techniques described herein-while they may be explained from the perspective and terminology of electricity-are applicable to any measured commodity. Thus, while smart electricity meter 106 is discussed, a natural gas, water, or other utility metering device could utilize the techniques discussed herein.

The smart electricity meter 106 may include a radio and antenna 126. Alternatively, the smart meter may include a PLC modem or other communications device. The smart electricity meter 106 may also include a battery and/or a power supply 128. In the example of a system configured as an electricity grid, a battery is not required. The power supply 128 is configured to provide regulated direct current (DC) power at prescribed voltage levels for operation of the processor 114, the memory device 116, the metrology device(s) 124, the radio and antenna 126, and/or other devices. A bus, printed circuit board, wiring harness, and/or other circuit connectivity device(s) 130 may be used to connect the processor 114, the memory device 116, the metrology devices 124, the radio and antenna 126, and the power supply 128.

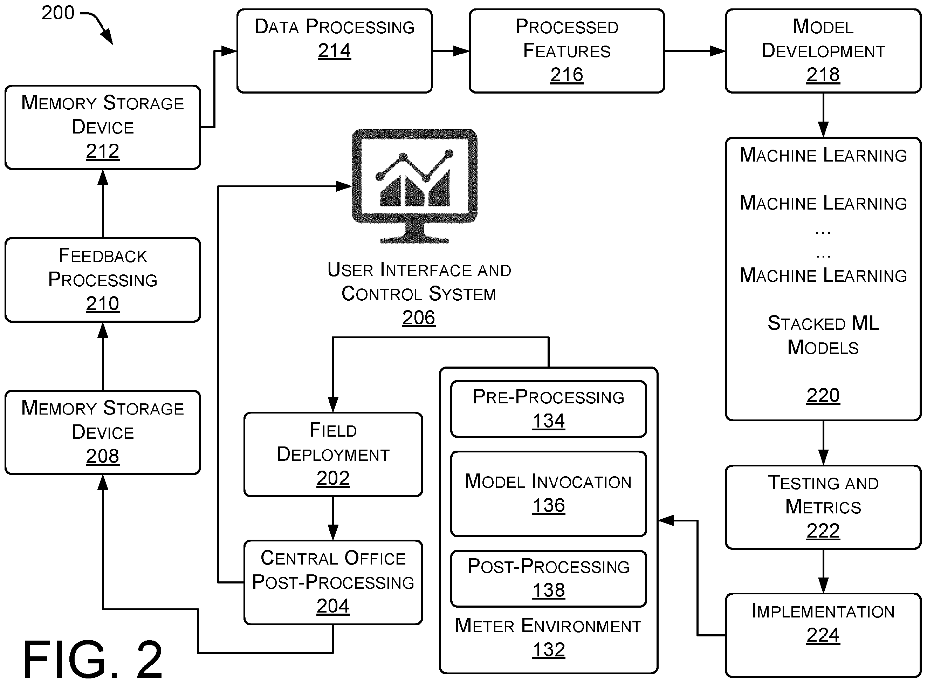

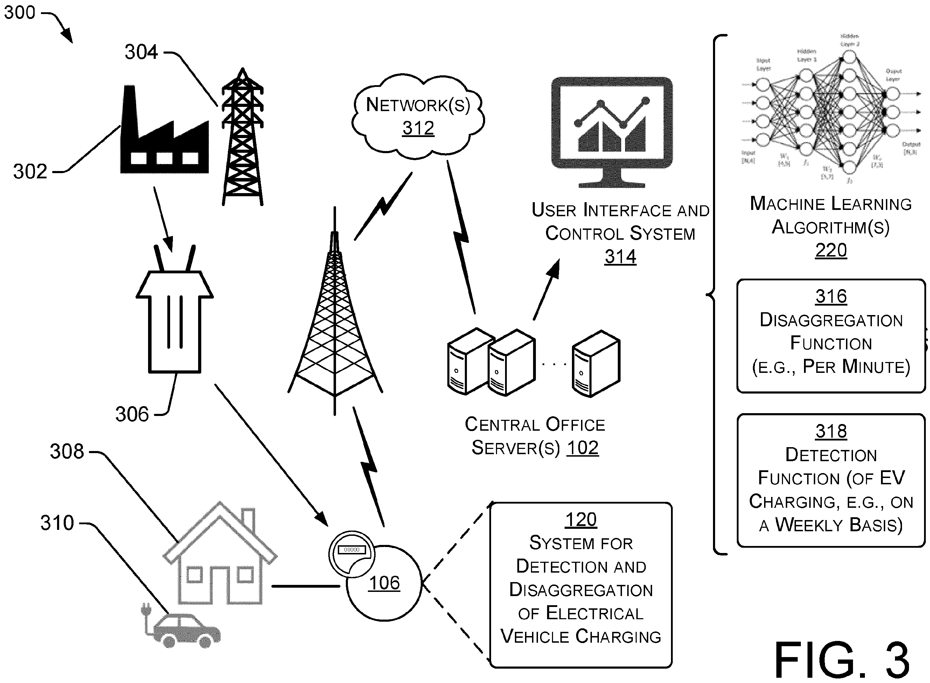

FIG. 1A shows example detail of the system 120 for disaggregation of loads and detection of electric vehicle (EV) charging on residential premises. An example metering environment 132 may include pre-processing activities 134, model invocation 136, and post-processing activities 138. In an example, a model is configured and utilized as part of the disaggregation of electrical loads at the electricity customer's site and for detection of electrical vehicle charging from among the disaggregated loads. FIGS. 2 and 3 show aspects of the model and other elements of the system.

In an example of the model 140, a set of tree-based algorithms are trained on data streams, such as by a method of cross-validation. In the example, the data streams include data based on mean, median, standard deviation and at least one other quantile of P (real power) and Q (reactive power) in multiple windows. In the example, the model is a stacked model, which is configured to receive the values for the mean, median, standard deviation, and the at least one other quantile of P and Q in the multiple windows.

FIG. 2 shows a system 200 for developing, deploying, and operating various devices, models, interfaces, techniques, and features of EV charging load detection. In the example, the system 200 comprises a cycle of events that continuously refine the model and data used to identify EV charging events, as well as the data used in pre-processing, post-processing, testing, machine learning, user interface(s), and other aspects.

At block 202, a field deployment may involve deployment of both the system 112 of the central office server(s) 102 and the system 120 of the smart electricity meter 106. The field deployment may involve the installation of a number of smart electricity meters under actual customer-based conditions or in a controlled test environment.

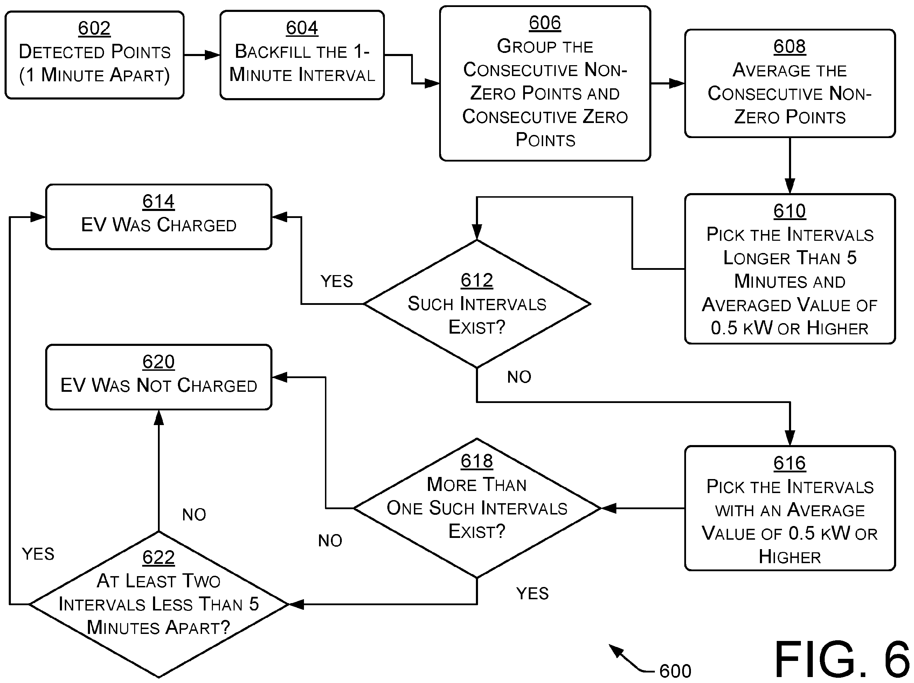

At block 204, central office (or any networked computing device) post-processing may include summary data provided to a user interface 206. Block 204 may also provide data to a memory storage device 208. The post-processing may be performed by the central office server(s) 102 or other (possibly cloud-based) computing device. An example of post-processing is seen in FIG. 6. The post-processing may determine EV charging events based on data that was originally obtained by metrology device(s).

At block 210, feedback processing refines the data from memory storage device 208 and sends the data to memory storage device 212 (which may be a different location on the same drive or device as memory storage device 208).

At block 214, further data processing results in processed features 216. In an example, the processed features include data (such as time-series of voltage measurements and current measurements) that may be used for model development 218. Values of value of the power, P, and the value of volt-amps-reactive (VAR), Q, may also be calculated. Machine learning unit 220 (e.g., using stacked machine learning models) helps to compute the disaggregated power of EV charging at the premises.

At block 222, testing and metrics may be performed on the model, as refined by the model development 218 and the machine learning stack 220. At block 224, the refined model may be implemented in metering devices and/or the central office server(s) 102. In an example, the implemented model may be instantiated in a metering environment, such as the smart electricity meter 106 of FIG. 1.

The metering environment 132 (previously shown in FIG. 1A) may include pre-processing 134, model invocation 136, and post-processing 138 functionality. In some implementations, the post-processing is performed by the central office server(s) 102.

FIG. 3 shows a second example system 300 for EV load detection. Generation facilities 302 and distribution facilities 304 provide power to a plurality of transformers 306 and associated smart electricity meters 106. The smart electricity meters are associated with customer sites 308 that are charging EV(s) 310. The smart electricity meter 106 may include a system 120 for load disaggregation and detection of electrical vehicle charging, which may be in communication over networks 312 with the central office server(s) 102. User interface and control system 314 allows the system to display information and/or receive commands. In the example, the system 112 (not shown) of the central office server(s) 102 is configured with algorithms based on machine-learning 220. In the example, the algorithms perform a disaggregation function 316 to disaggregate a load of a smart electricity meter to determine its constituent parts. In the example, the customer's electrical load may be disaggregated on a per-minute frequency. In other examples, periods longer or shorter than a minute could be utilized. A detection function 318 is configured to determine EV charging activity (e.g., the charging activity may include an indication that an EV was charged, and the power and/or energy used, etc.). In an example, the detection function 318 may be run on a weekly basis, and may receive the output of the disaggregation function 316 as input. In other examples, periods longer or shorter than a week could be utilized.

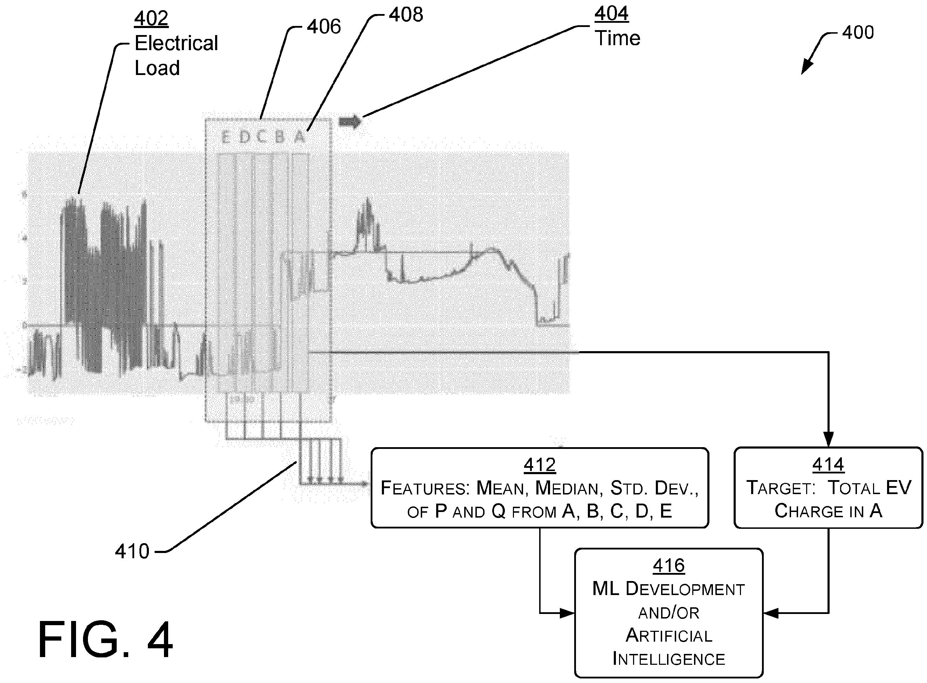

FIG. 4 shows a method 400 including techniques utilizing windows and sub-windows in time to manage data. In an example, the features (mean, median, standard deviation, etc. of P and Q, having been obtained from 5 sub-windows E, D, C, B, and A are fed into the pre-trained machine learning (ML) and/or artificial intelligence (AI) model. The ML/AI model then estimates the amount of EV charged at the sub-window A, which can be called "the target." This approach is used to develop (i.e., train) an ML/AI model, and may be performed on a computer, such as by the operation of software and/or using the input of a development engineer or trained technician. Once trained, instances of the model may then be installed on respective devices, such as smart electricity meters.

Electrical load is shown as power 402 with respect to time 404. A window in time 406 includes five sub-windows, with sub-window A 408 being the most recent in time. The output 410 of each sub-window indicates aspects of the energy consumed at a customer's site over the duration of the sub-window in time. In the example of block 412, the data output by each sub-window includes features comprising: the mean, the median, and the standard deviation, of P and of Q. At block 414 a target is set to be the total EV charge in sub-window A. At block 416, a machine learning and/or artificial intelligence system uses the features indicated by block 412 to determine/estimate the target indicated by block 414 to identify EV charging events.

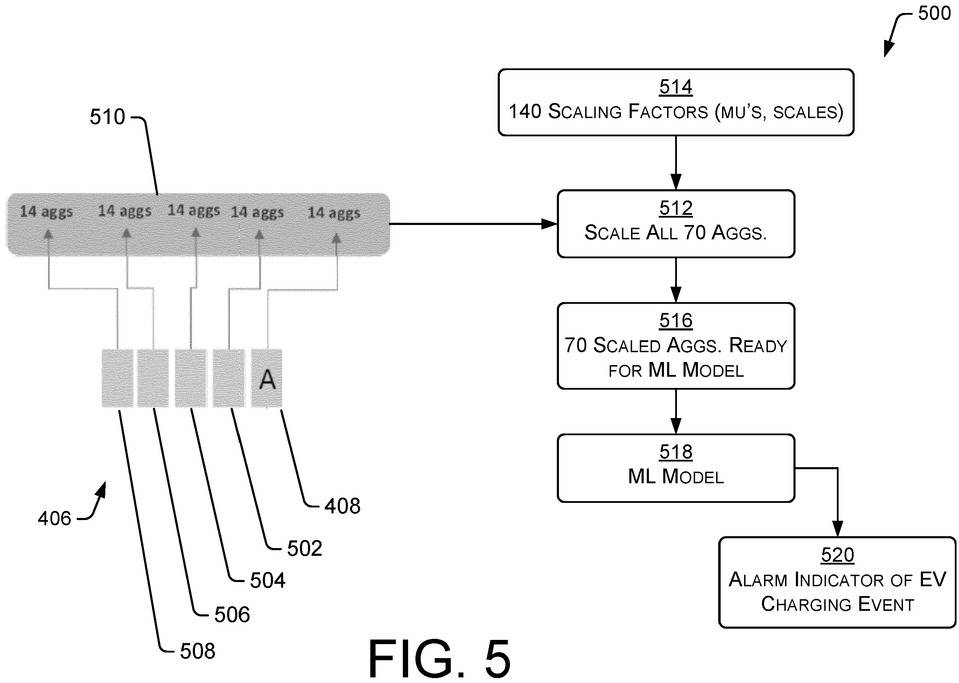

FIG. 5 shows a method 500 for analyzing data obtained from windows in time. The window 406 in time may span a one-minute interval of time. The window 406 may include the most recent sub-window 408, both of which were previously shown in FIG. 4. Additional sub-windows 502, 504, 506, 508 are shown. The output 510 of each sub-window includes 14 aggregations. At block 512, the aggregations are scaled, such as by the 140 scaling factors of block 514. At block 516, 70 scaled aggregations are ready to be sent as input to block 518 for processing by a machine-learning model. The machine-learning model determines if an EV charging event is present. If so, at block 520 an alarm or other indicator signals and/or records the EV charging event.

### Example Methods

In some examples, the techniques discussed herein may be implemented by one more processors accessing software defined on one or more memory devices. The processor(s) and/or memory device(s) may be located on an electricity meter and/or a cloud-based server (e.g., a server of a utility company). If the functionality is distributed, software may reside on both the electricity meter and the server.

In other examples of the techniques discussed herein, the methods of operation may be performed by one or more application specific integrated circuits (ASIC) or may be performed by a general-purpose processor utilizing software defined in computer-readable media. In the examples and techniques discussed herein, the memory may comprise computer-readable media and may take the form of volatile memory, such as random-access memory (RAM) and/or non-volatile memory, such as read only memory (ROM) or flash RAM. Computer-readable media devices include volatile and non-volatile, removable, and non-removable media implemented in any method or technology for storage of information such as computer-readable instructions, data structures, program modules, or other data for execution by one or more processors of a computing device. Examples of computer-readable media include, but are not limited to, phase-change memory (PRAM), static random-access memory (SRAM), dynamic random-access memory (DRAM), other types of random access memory (RAM), read-only memory (ROM), electrically erasable programmable read-only memory (EEPROM), programmable read-only memory (PROM), flash memory or other memory technology, compact disk read-only memory (CD-ROM), digital versatile disks (DVD) or other optical storage, magnetic cassettes, magnetic tape, magnetic disk storage or other magnetic storage devices, or any other non-transitory medium that can be used to store information for access by a computing device.

As defined herein, computer-readable media includes non-transitory media, and does not include transitory media, such as modulated data signals and carrier waves, and/or other information-containing signals.

FIG. 6 shows a method 600 including techniques for post-processing and decision-making (inference) regarding whether an EV charging event occurred and estimating the level of charging and its duration. In the example of FIG. 2, the central office server(s) 102 may perform the post-processing method 600. In the example of block 602, detected points are one-minute apart. The detected points are estimations of EV charging within a disaggregated load. At block 606, consecutive non-zero points and consecutive zero points are grouped. At block 608, the consecutive non-zero points are averaged. (Note that consecutive zero points indicate the periods at which no EV charging has been detected. Accordingly, non-zero points are averaged.) At block 610, intervals longer than five minutes and having an average value of 0.5 kW or higher are picked.

At block 612 it is determined if any such interval(s) were picked. These intervals are associated with longer use of higher power consuming devices, such as an EV charging station. If such interval(s) exist, at block 614 an EV charging event is indicated.

If no intervals having the two characteristics of block 610 are found at block 612, then at block 616 only the intervals having an average value of 0.5 kW or higher are picked. At block 618, it is determined if more than one such interval exists. If not, then at block 620 an EV charging event is not indicated.

If more than one interval with an average value of 0.5 kW or higher exists, then at block 622 it is determined if there are at least two such intervals less than five minutes apart. If not, then at block 620 an EV was not charged. However, if at least two such intervals less than five minutes apart exist, then at block 614 an EV charging event is present.

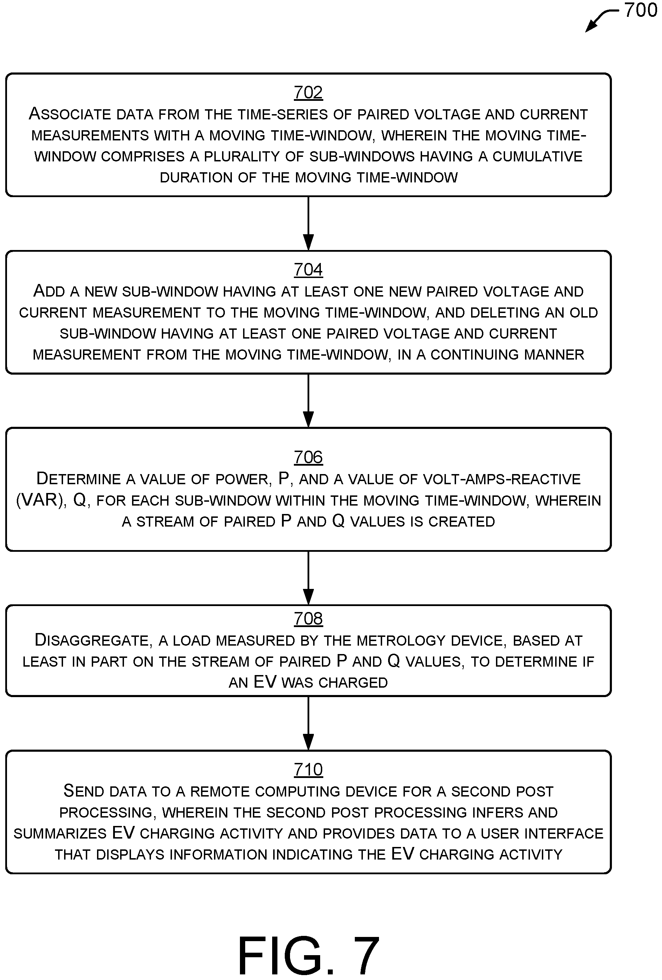

FIG. 7 shows an example method 700 for service site power disaggregation and detection of EV charging. The disaggregation function divides an overall power usage at a customer site to determine if EV charging station(s) were operational. The method 700 may be performed by the smart electricity meter 106, the central office server(s) 102, and/or an alternative computing device.

At block 702, data from the time-series of paired voltage and current measurements is associated with a moving time-window, wherein the moving time-window comprises a plurality of sub-windows having a cumulative duration of the moving time-window.

At block 704, a new sub-window having at least one new paired voltage and current measurement is added to the moving time-window. Simultaneously, an old sub-window having at least one paired voltage and current measurement is deleted from the moving time-window. The paired voltage and current measurements constitute power measurements. Accordingly, the addition of a new sub-window and the deletion of an older sub-window is performed in a continuing manner. Thus, the sub-windows are associated with the newest readings from the time-series of paired voltage and current measurements. Alternatively, the sub-windows may be associated with values of P and Q, as seen at block 412 of FIG. 4. Thus, as the time window moves, the metrology device 124 continues to add to the time-series of paired voltage and current measurements, resulting in the P and Q data that is added to each sub-window.

At block 706, a value of power, P, and a value of volt-amps-reactive (VAR), Q, for each sub-window within the moving time-window is determined. The values for P and Q are determined in a continuous manner, thereby creating a stream of paired P and Q values.

At block 708, a load measured by the metrology device, based at least in part on the stream of paired P and Q values, is disaggregated to determine EV charging activity (e.g., the charging activity may include an indication that an EV was charged, and the power and/or energy used, etc.).

In the example of block 710 the post-processing and determination of EV charging events may be performed remotely, such as by the central office server(s) 102. Accordingly, data is sent to a remote computing device for a second post-processing, wherein the second post-processing infers and summarizes EV charging activity and provides data to a user interface that displays information indicating the EV charging activity.

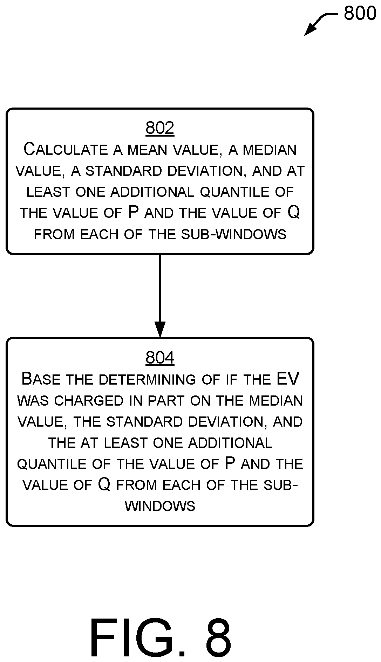

FIG. 8 shows an example method 800 by which windows and sub-windows are used as a tool in the disaggregation and detection processes. Accordingly, the method 800 provides an example by which the determination of an EV charging event may be performed. At block 802, a mean value, a median value, a standard deviation, and at least one additional quantile of the value of P and the value of Q is calculated for, and associated with, each of the sub-windows. At block 804, the determining of EV charging activity is based at least in part on: the median value; the standard deviation; and the at least one additional quantile of the value of P and the value of Q from each of the sub-windows.

### Example Systems, Devices, and Methods

The following examples of detection and disaggregation of electrical vehicle charging are expressed as numbered clauses. While the examples illustrate a number of possible configurations and techniques, they are not meant to be an exhaustive or limiting listing of the systems, methods, and/or techniques described herein.
1. An electricity meter, comprising: a processor; one or more memory devices in communication with the processor; a metrology device in communication with the processor and configured to create a time-series of paired voltage and current measurements; and a model configured to detect electric vehicle (EV) charging, wherein the model is defined in the one or more memory devices and performs actions comprising: associating data from the time-series of paired voltage and current measurements with a moving time-window, wherein the moving time-window comprises a plurality of sub-windows having a cumulative duration of the moving time-window; adding a new sub-window having at least one new paired voltage and current measurement to the moving time-window, and deleting an old sub-window having at least one paired voltage and current measurement from the moving time-window, in a continuing manner; determining a value of power, P, and a value of volt-amps-reactive (VAR), Q, for each sub-window within the moving time-window, wherein a stream of paired P and Q values is created; and disaggregating a load measured by the metrology device, based at least in part on the stream of paired P and Q values, to determine if an EV was charged and/or EV charging activity (e.g., the charging activity may include an indication that an EV was charged, and the power and/or energy used, etc.).
2. The electricity meter of clause 1, wherein the actions additionally comprise: calculating a mean value, a median value, a standard deviation, and at least one additional quantile of the value of P and the value of Q from each of the sub-windows; wherein the determining if the EV was charged and/or EV charging activity is based in part on the median value, the standard deviation, and the at least one additional quantile of the value of P and the value of Q from each of the sub-windows.
3. The electricity meter of clause 1 or 2, additionally comprising: a pre-processing application, wherein the pre-processing application is defined in the one or more memory devices and receives the time-series of paired voltage and current measurements from the metrology device; and a post-processing application, wherein the post-processing application is defined in the one or more memory devices and receives EV charging data from the model.
4. The electricity meter of clause 3, wherein the actions additionally comprise: sending data to a remote computing device for a second post-processing, wherein the second post-processing infers and summarizes EV charging activity and provides data to a user interface that displays information indicating the EV charging activity.
5. The electricity meter of any preceding clause, wherein the model is a stacked model, and wherein the stacked model comprises: a set of tree-based algorithms trained on data streams by a method of cross-validation, wherein the data streams comprise data based on mean, median, standard deviation and at least one other quantile of P and Q in multiple windows, and wherein the stacked model is configured for receiving mean, median, standard deviation, and the at least one other quantile of P and Q in the multiple windows.
6. The electricity meter of any preceding clause, wherein the actions additionally comprise: disaggregating electricity use more frequently than once per hour; and wherein the determining if the EV was charged and/or EV charging activity is performed more frequently than once per day and is based in part on the disaggregating of electricity use.
7. The electricity meter of any preceding clause, wherein the actions additionally comprise: disaggregating electricity use with a frequency of once per second; and wherein the determining if the EV was charged and/or EV charging activity is performed with a frequency of once per minute, and is based at least in part on the disaggregating of electricity use.
8. A method, comprising: associating data from a time-series of paired voltage and current measurements made by a metrology device of an electricity meter with a moving time-window, wherein the moving time-window comprises a plurality of sub-windows having a cumulative duration of the moving time-window; adding a new sub-window having at least one new paired voltage and current measurement to the moving time-window, and deleting an old sub-window having at least one paired voltage and current measurement from the moving time-window, in a continuing manner; determining a value of power, P, and a value of volt-amps-reactive (VAR), Q, for each sub-window within the moving time-window, wherein a stream of paired P and Q values is created; and disaggregating a load measured by the metrology device, based at least in part on the stream of paired P and Q values, to determine if an electric vehicle (EV) was charged and/or EV charging activity.
9. The method of clause 8, additionally comprising: calculating a mean value, a median value, a standard deviation, and at least one additional quantile of the value of P and the value of Q from each of the sub-windows; wherein the determining if the EV was charged and/or EV charging activity is based in part on the median value, the standard deviation, and the at least one additional quantile of the value of P and the value of Q from each of the sub-windows.
10. The method of clause 8 or 9, additionally comprising: sending data to a remote computing device for post-processing, wherein the post-processing infers and summarizes EV charging activity and provides data to a user interface that displays information indicating the EV charging activity.
11. The method of any of clauses 8 to 10, additionally comprising: disaggregating electricity use more frequently than once per hour; and wherein the determining if the EV was charged and/or EV charging activity is performed more frequently than once per day and is based in part on the disaggregating of electricity use.
12. The method of any of clauses 8 to 11, additionally comprising: disaggregating electricity use with a frequency of once per second; and wherein the determining if the EV was charged and/or EV charging activity is performed with a frequency of once per minute, and is based at least in part on the disaggregating of electricity use.
13. The method of any of clauses 8 to 12, wherein at least part of the method is performed by a stacked model, and wherein method additionally comprises: training a set of tree-based algorithms on data streams using cross-validation, wherein the data streams comprise data based on mean, median, standard deviation and at least one other quantile of P and Q in multiple windows, and wherein the stacked model is configured for receiving mean, median, standard deviation, and the at least one other quantile of P and Q in the multiple windows.
14. The method of any of clauses 8 to 13, additionally comprising: receiving the time-series of paired voltage and current measurements from the metrology device at a pre-processing application, wherein the pre-processing application is defined in one or more memory devices; and receiving EV charging data at a post-processing application, wherein the post-processing application is defined in the one or more memory devices; wherein a model comprises the pre-processing application and the post-processing application, and wherein the model is configured to determine if the EV was charged and/or EV charging activity.
15. One or more non-transitory computer-readable media storing computer-executable instructions that, when executed by one or more processors, configure a computing device to perform actions comprising: associating data from a time-series of paired voltage and current measurements made by a metrology device of an electricity meter with a moving time-window, wherein the moving time-window comprises a plurality of sub-windows having a cumulative duration of the moving time-window; adding a new sub-window having at least one new paired voltage and current measurement to the moving time-window, and deleting an old sub-window having at least one paired voltage and current measurement from the moving time-window, in a continuing manner; determining a value of power, P, and a value of volt-amps-reactive (VAR), Q, for each sub-window within the moving time-window, wherein a stream of paired P and Q values is created; and disaggregating a load measured by the metrology device, based at least in part on the stream of paired P and Q values, to determine if an EV was charged and/or EV charging activity.
16. The one or more non-transitory computer-readable media as recited in clause 15, wherein the actions additionally comprise: calculating a mean value, a median value, a standard deviation, and at least one additional quantile of the value of P and the value of Q from each of the sub-windows; wherein the determining if the EV was charged and/or EV charging activity is based in part on the median value, the standard deviation, and the at least one additional quantile of the value of P and the value of Q from each of the sub-windows.
17. The one or more non-transitory computer-readable media as recited in clause 15 or 16, wherein the actions additionally comprise: sending data to a remote computing device for post-processing, wherein the post-processing infers and summarizes EV charging activity and provides data to a user interface that displays information indicating the EV charging activity.
18. The one or more non-transitory computer-readable media as recited in any of clauses 15 to 17, wherein the actions additionally comprise: disaggregating electricity use more frequently than once per hour; and wherein the determining if the EV was charged and/or EV charging activity is performed more frequently than once per day and is based in part on the disaggregating of electricity use.
19. The one or more non-transitory computer-readable media as recited in any of clauses 15 to 18, wherein the actions additionally comprise: disaggregating electricity use with a frequency of once per second; and wherein the determining if the EV was charged and/or EV charging activity is performed with a frequency of once per minute, and is based at least in part on the disaggregating of electricity use.
20. The one or more non-transitory computer-readable media as recited in any of clauses 15 to 19, wherein the actions additionally comprise: receiving the time-series of paired voltage and current measurements from the metrology device at a pre-processing application, wherein the pre-processing application is defined in the one or more non-transitory computer-readable media; and receiving EV charging data at a post-processing application, wherein the post-processing application is defined in the one or more non-transitory computer-readable media; wherein a model comprises the pre-processing application and the post-processing application, and wherein the model is configured to determine if the EV was charged and/or EV charging activity.

### Conclusion

Although the subject matter has been described in language specific to structural features and/or methodological actions, it is to be understood that the subject matter defined in the appended claims is not necessarily limited to the specific features or actions described. Rather, the specific features and actions are disclosed as exemplary forms of implementing the claims.

The words comprise, comprises, and/or comprising, when used in this specification and/or claims specify the presence of stated features, devices, techniques, and/or components. The words do not preclude the presence or addition of one or more other features, devices, techniques, and/or components and/or groups thereof.

## Claims

1. An electricity meter, comprising:
a processor;
one or more memory devices in communication with the processor;
a metrology device in communication with the processor and configured to create a time-series of paired voltage and current measurements; and
a model configured to detect electric vehicle (EV) charging, wherein the model is defined in the one or more memory devices and performs actions comprising:
associating data from the time-series of paired voltage and current measurements with a moving time-window, wherein the moving time-window comprises a plurality of sub-windows having a cumulative duration of the moving time-window;
adding a new sub-window having at least one new paired voltage and current measurement to the moving time-window, and deleting an old sub-window having at least one paired voltage and current measurement from the moving time-window, in a continuing manner;
determining a value of power, P, and a value of volt-amps-reactive (VAR), Q, for each sub-window within the moving time-window, wherein a stream of paired P and Q values is created; and
disaggregating a load measured by the metrology device, based at least in part on the stream of paired P and Q values, to determine if an EV was charged.

2. The electricity meter of claim 1, wherein the actions additionally comprise:
calculating a mean value, a median value, a standard deviation, and at least one additional quantile of the value of P and the value of Q from each of the sub-windows;
wherein the determining if the EV was charged is based in part on the median value, the standard deviation, and the at least one additional quantile of the value of P and the value of Q from each of the sub-windows.

3. The electricity meter of claim 1 or 2, additionally comprising:
a pre-processing application, wherein the pre-processing application is defined in the one or more memory devices and receives the time-series of paired voltage and current measurements from the metrology device; and
a post-processing application, wherein the post-processing application is defined in the one or more memory devices and receives EV charging data from the model.

4. The electricity meter of any preceding claim, wherein the actions additionally comprise:
sending data to a remote computing device for a second post-processing, wherein the second post-processing infers and summarizes EV charging activity and provides data to a user interface that displays information indicating the EV charging activity.

5. The electricity meter of any preceding claim, wherein the model is a stacked model, and wherein the stacked model comprises:
a set of tree-based algorithms trained on data streams by a method of cross-validation, wherein the data streams comprise data based on mean, median, standard deviation and at least one other quantile of P and Q in multiple windows, and wherein the stacked model is configured for receiving mean, median, standard deviation, and the at least one other quantile of P and Q in the multiple windows.

6. The electricity meter of any preceding claim, wherein the actions additionally comprise:
disaggregating electricity use more frequently than once per hour; and
wherein the determining if the EV was charged is performed more frequently than once per day and is based in part on the disaggregating of electricity use.

7. The electricity meter of any preceding claim, wherein the actions additionally comprise:
disaggregating electricity use with a frequency of once per second; and
wherein the determining if the EV was charged is performed with a frequency of once per minute, and is based at least in part on the disaggregating of electricity use.

8. A method, comprising:
associating data from a time-series of paired voltage and current measurements made by a metrology device of an electricity meter with a moving time-window, wherein the moving time-window comprises a plurality of sub-windows having a cumulative duration of the moving time-window;
adding a new sub-window having at least one new paired voltage and current measurement to the moving time-window, and deleting an old sub-window having at least one paired voltage and current measurement from the moving time-window, in a continuing manner;
determining a value of power, P, and a value of volt-amps-reactive (VAR), Q, for each sub-window within the moving time-window, wherein a stream of paired P and Q values is created; and
disaggregating a load measured by the metrology device, based at least in part on the stream of paired P and Q values, to determine if an electric vehicle (EV) was charged.

9. The method of claim 8, additionally comprising:
calculating a mean value, a median value, a standard deviation, and at least one additional quantile of the value of P and the value of Q from each of the sub-windows;
wherein the determining if the EV was charged is based in part on the median value, the standard deviation, and the at least one additional quantile of the value of P and the value of Q from each of the sub-windows.

10. The method of claim 8 or 9, additionally comprising:
sending data to a remote computing device for post-processing, wherein the post-processing infers and summarizes EV charging activity and provides data to a user interface that displays information indicating the EV charging activity.

11. The method of any of claims 8 to 10, additionally comprising:
disaggregating electricity use more frequently than once per hour; and
wherein the determining if the EV was charged is performed more frequently than once per day and is based in part on the disaggregating of electricity use.

12. The method of any of claims 8 to 11, additionally comprising:
disaggregating electricity use with a frequency of once per second; and
wherein the determining if the EV was charged is performed with a frequency of once per minute, and is based at least in part on the disaggregating of electricity use.

13. The method of any of claims 8 to 12, wherein at least part of the method is performed by a stacked model, and wherein method additionally comprises:
training a set of tree-based algorithms on data streams using cross-validation, wherein the data streams comprise data based on mean, median, standard deviation and at least one other quantile of P and Q in multiple windows, and wherein the stacked model is configured for receiving mean, median, standard deviation, and the at least one other quantile of P and Q in the multiple windows.

14. The method of any of claims 8 to 13, additionally comprising:
receiving the time-series of paired voltage and current measurements from the metrology device at a pre-processing application, wherein the pre-processing application is defined in one or more memory devices; and
receiving EV charging data at a post-processing application, wherein the post-processing application is defined in the one or more memory devices;
wherein a model comprises the pre-processing application and the post-processing application, and wherein the model is configured to determine if the EV was charged.

15. One or more computer-readable media storing computer-executable instructions that, when executed by one or more processors, configure a computing device to perform the method of any of claims 8 to 14.
